# EUROPÄISCHE PATENTANMELDUNG

(11) **EP 2 159 190 A2**
(43) Veröffentlichungstag der Anmeldung: **03.03.2010**
(21) Anmeldenummer: 09164667.9
(22) Anmeldetag: 06.07.2009
(51) Int. Cl.: B81C 1/00

(54) **Verfahren zum Verkapseln eines MEMS Bauelement**

(30) Priorität: 28.08.2008 DE 102008041674
(71) Anmelder: ROBERT BOSCH GMBH, 70442 Stuttgart (DE)
(72) Erfinder: Herrmann, Ingo, 71292, Friolzheim (DE); Reinhart, Karl-Franz, 74189, Weinsberg (DE); Herrmann, Daniel, 72072, Tuebingen (DE); Freund, Frank, 70439, Stuttgart (DE); Feyh, Ando, 71732, Tamm (DE); Eckardt, Martin, 70197, Stuttgart (DE)

(57) **Zusammenfassung**

Die vorliegende Erfindung schafft ein mikromechanisches Bauelement und ein entsprechendes Herstellungsverfahren. Das mikromechanische Bauelement umfasst eine erste Komponente (102); und eine zweite Komponente (101), mit der die erste Komponente (102) durch einen Legierungsbereich (150) verbunden ist; wobei die erste und zweite Komponente (102; 101) einen Vakuumbereich (104) oder Restgasbereich (104) einschließen, der durch den Legierungsbereich (150) abgedichtet ist.

## Beschreibung

### STAND DER TECHNIK

Die vorliegende Erfindung betrifft ein mikromechanisches Bauelement und ein entsprechendes Herstellungsverfahren.

Obwohl auf beliebige mikromechanische Bauelemente mit einem Vakuumbereich bzw. Restgasbereich anwendbar, werden die vorliegende Erfindung und die ihr zugrundeliegende Problematik im Hinblick auf einen mikromechanischen Infrarotsensor erläutert.

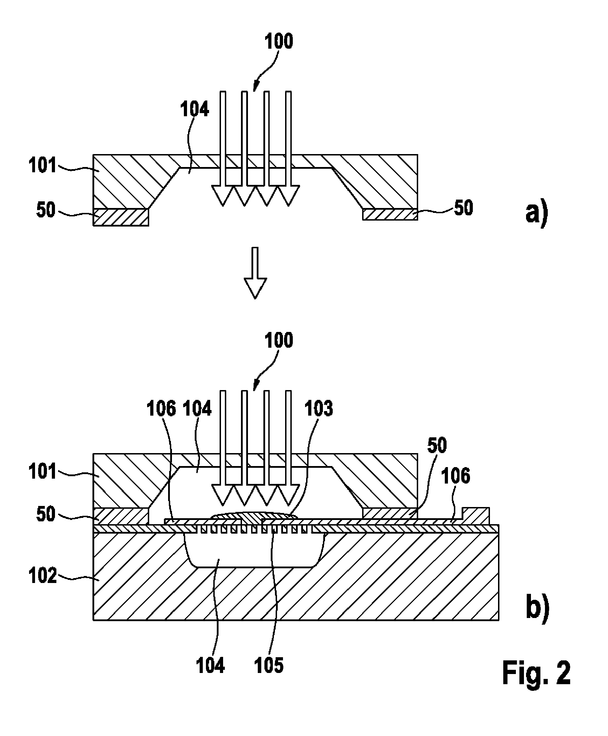

Aus der DE 10 2004 020 685 B3 ist ein Sensor zum Detektieren von einfallender infraroter Strahlung bekannt, welcher in Fig. 2a, b dargestellt ist.

Dieser bekannte Infrarotsensor enthält einen durch einen Sensorchip 102 und einen Kappenchip 101 eingeschlossenen Vakuumbereich 104, der durch jeweilige Kavernen des Sensorchips 102 und des Kappenchips 101 gebildet ist. Auf einer perforierten Membran 105 befindet sich eine Absorptionsschicht 103, welche einen Thermopile 106 wenigstens teilweise überdeckt. Mit Bezugszeichen 100 ist die durch den Kappenchip 101 von oben einfallende infrarote Strahlung gekennzeichnet, welche zur Erwärmung der Absorptionsschicht 103 und damit der darunter liegenden Kontakte des Thermopiles führt.

Die sich dadurch ergebende Temperaturdifferenz zwischen den von der Absorptionsschicht 105 bedeckten Warmkontakten des Thermopiles und den nicht von der Absorptionsschicht bedeckten Kaltkontakten des Thermopiles führt zu einer elektrischen Spannung, welche ein Maß für die Intensität der Infrarotstrahlung ist.

Der Kappenchip 101 ist mit dem Sensorchip 102 durch eine Waferlevelverpackung (WLP) verbunden, wobei der Verbindungsbereich durch eine Sealglasschicht 50 abgedichtet ist. Bei der Herstellung wird die Sealglasschicht 50 auf den unteren Rand des Kappenchips 101 aufgedruckt und anschließend erfolgt eine thermische Verbindung mit dem Sensorchip 101.

Aus Kostengründen und wegen des Aufbaus sind derartige Waferlevelverpackungen besonders vorteilhaft. Als nachteilig bei bisherigen, auf Sealglas 50 aufbauenden Waferlevelverpackungen hat sich jedoch herausgestellt, dass Restgasanteile, die z. B. durch Ausgasen organischer Reste des Sealglases 50 im Prozess und danach entstehen, zu einer Verschlechterung des Vakuums im Vakuumbereich 104 führen, was wiederum wegen erhöhter Wärmeableitung des Restgases die durch die zu detektierende Temperaturstrahlung erzeugte Übertemperatur des Infrarotsensors verringert und somit dessen Sensitivität verschlechtert.

Als indirekte Abhilfe für dieses Problem wurde in der DE 10 2004 020 685 B3 vorgeschlagen, für die Absorptionsschicht 103 ein infrarot-absorbierendes Material mit gleichzeitiger Getterwirkung zu verwenden, beispielsweise Zirkonium. Jedoch lässt eine derartige Getterwirkung im Laufe der Zeit nach.

### VORTEILE DER ERFINDUNG

Das in Anspruch 1 definierte erfindungsgemäße mikromechanische Bauelement sowie das entsprechende Herstellungsverfahren nach Anspruch 7 weisen den Vorteil auf, dass es einen verringerten und gut beherrschbaren Restgasdruck im Vakuumbereich bzw. Restgasbereich gibt.

Die Verwendung von legierungsbildenden Metall/Metall- oder Metall/Halbleiter-Materialien als Kontaktpartner auf den beiden Komponenten, z.B. Schaltungswafer bzw. Kappenwafer zum Verbinden beider Komponenten im Vakuum mittels Druck- und Temperaturbeaufschlagung (eutektisches Bonden) erlaubt eine erhöhte Sensorempfindlichkeit, eine sichere Einstellung der Empfindlichkeit in der Fertigung (Arbeitspunkt im Druckplateau der Empfindlichkeits-/Druck-Kurve) sowie eine bessere Lebensdauerstabilität des Vakuumeinschlusses.

Die in den jeweiligen Unteransprüchen aufgeführten Merkmale beziehen sich auf vorteilhafte Weiterbildungen und Verbesserungen des betreffenden Gegenstandes der Erfindung.

Gemäß einer bevorzugten Weiterbildung weist der Legierungsbereich eine Au-Si-Legierung auf.

Gemäß einer weiteren bevorzugten Weiterbildung weist der Legierungsbereich eine Ge-Al-Legierung auf.

Gemäß einer weiteren bevorzugten Weiterbildung ist die erste Komponente ein Sensorwafer oder Sensorchip und die zweite Komponente ein Kappenwafer oder Kappenchip.

Gemäß einer weiteren bevorzugten Weiterbildung weist mindestens eine der ersten und zweiten Komponente eine Kaverne auf, die den Vakuumbereich bzw. Restgasbereich bildet.

Gemäß einer weiteren bevorzugten Weiterbildung ist das mikromechanisches Bauelement eine Infrarotsensorvorrichtung.

### ZEICHNUNGEN

Ausführungsbeispiele der Erfindung sind in der Zeichnung dargestellt und in der nachfolgenden Beschreibung näher erläutert.

### Es zeigen:

- Fig. 1a-c: schematische Querschnittsdarstellungen zur Erläuterung eines Herstellungsverfahrens einer mikromechanischen Infrarotsensorvorrichtung gemäß einer Ausführungsform der vorliegenden Erfindung; und
- Fig. 2a,b: schematische Querschnittsdarstellungen zur Erläuterung eines Herstellungsverfahrens einer aus der DE 10 2004 020 685 B3 bekannten mikromechanischen Infrarotsensorvorrichtung.

### BESCHREIBUNG VON AUSFÜHRUNGSBEISPIELEN

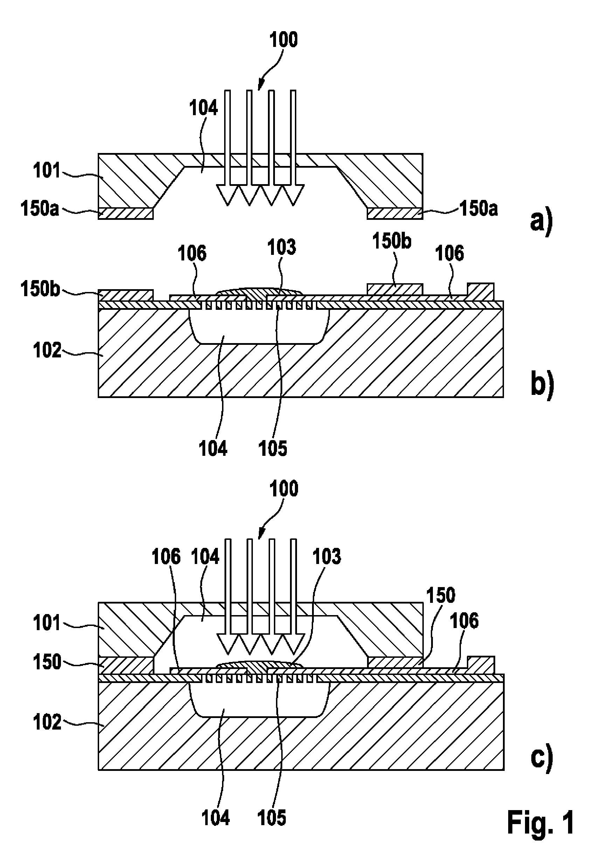

In Fig. 1a - c bezeichnen dieselben Bezugszeichen wie in Fig. 2a, 2b dieselben Elemente, weshalb eine wiederholte Beschreibung unterlassen wird.

Im Gegensatz zu Fig. 2a, b ist im unteren Randbereich des Kappenchips 101 eine Goldschicht 150a aufgebracht, wohingegen eine entsprechende Siliziumschicht 150b auf dem Verbindungsbereich des Sensorchips 102 aufgebracht ist. Zum Zusammenfügen des Kappenchips 101 und des Sensorchips 102 werden beide in definierte Vakuumatmosphäre gebracht und mit einer Temperatur entsprechend einer eutektischen Legierung von Gold und Silizium anschließend zusammengefügt. Nach dem Abkühlen ist im Vakuumbereich 104 ein Vakuum von typischerweise 0,1 - 1 mbar vorgesehen, das durch die eutektische Au-Si-Legierung 150 gut abgedichtet ist. Der Restgasdruck im Vakuumbereich 104 liegt in der Größenordnung des während der Verschlussphase anliegenden Vakuumdrucks. Im Gegensatz zum bekannten Sealglas kommt es bei der eutektischen Au-Si-Legierung 150 zu keinem Ausgasen, weshalb das Vakuum im Vakuumbereich 104 stabil ist, also keiner Verschlechterung unterliegt.

Das Aufbringen der beiden Legierungspartner 150a, 150b erfolgt zweckmäßigerweise durch eine Abscheidung und eine anschließende Strukturierung, beispielsweise durch Ätzen. Ebenso denkbar ist eine maskierte Abscheidung.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Insbesondere ist die Erfindung nicht nur auf mikromechanische Infrarotsensorvorrichtungen anwendbar, sondern auf beliebige mikromechanische Bauelemente mit einer Verkappung.

Als Legierungsmaterialien kommen neben der Paarung Au-, Si- auch insbesondere Al-, Ge- oder andere Metall-/Metall-Legierungen oder Metall/Halbleiter-Legierungen in Frage, welche frei von Ausgasungen sind. Jeweils ein Legierungsmaterialpartner liegt dabei vor dem eutektischen Bonden auf dem Kappenrand vor, und der jeweils andere Materialpartner auf der zukünftigen Verschlussfläche des Sensorwafers.

Sensoren in Form von Infrarotsensorvorrichtungen mit einem derartigen Aufbau können beispielsweise als Einzelsensoren für Strahlungstemperaturmessung und/oder Infrarotgassensorik eingesetzt werden, aber auch als integriertes Fern- oder Nah-Infrarotarray für die Erkennung von Temperaturbildern oder Lebewesen in der Sicherheitstechnik oder in Fahrzeugnachtsichtsystemen.

Obwohl die obige Ausführungsform die Verbindung eines Kappenchips mit einem Sensorchip beschreibt, ist die Erfindung auch auf die Verbindung eines Kappenwafers mit einem Sensorwafer oder auf sonstige verkappte Bauelemente anwendbar.

## Patentansprüche

1. Mikromechanisches Bauelement mit:
einer ersten Komponente (102); und
einer zweiten Komponente (101), mit der die erste Komponente (102) durch einen Legierungsbereich (150) verbunden ist;
wobei die erste und zweite Komponente (102; 101) einen Vakuumbereich (104) oder Restgasbereich (104) einschließen, der durch den Legierungsbereich (150) abgedichtet ist.

2. Mikromechanisches Bauelement nach Anspruch 1, wobei der Legierungsbereich (150) eine Au-Si-Legierung aufweist.

3. Mikromechanisches Bauelement nach Anspruch 1 oder 2, wobei der Legierungsbereich (150) eine Ge-Al-Legierung aufweist.

4. Mikromechanisches Bauelement nach einem der vorhergehenden Ansprüche, wobei die erste Komponente (102) ein Sensorwafer oder Sensorchip und die zweite Komponente ein Kappenwafer oder Kappenchip ist.

5. Mikromechanisches Bauelement nach einem der vorhergehenden Ansprüche, wobei eine der ersten und zweiten Komponente (102; 101) eine Kaverne aufweist, die den Vakuumbereich bzw. Restgasbereich bildet.

6. Mikromechanisches Bauelement nach einem der vorhergehenden Ansprüche, welches eine Infrarotsensorvorrichtung ist.

7. Herstellungsverfahren für ein mikromechanisches Bauelement mit den Schritten:
thermisches Verbinden einer ersten Komponente (102) und einer zweiten Komponente (101) durch einen Legierungsbereich (150) in einer Vakuumatmosphäre oder Restgasatmosphäre derart, dass die erste und zweite Komponente (102; 101) einen Vakuumbereich (104) oder Restgasbereich (104) einschließen, der durch den Legierungsbereich (150) abgedichtet ist.

8. Herstellungsverfahren nach Anspruch 7, wobei vor dem Verbinden auf die erste Komponente (102) ein Bereich mit einem ersten Legierungspartner (150a) und auf die zweite Komponente (101) ein Bereich mit einem zweiten Legierungspartner (150b) aufgebracht werden, wobei der Bereich mit dem ersten Legierungspartner (150a) und der Bereich mit einem zweiten Legierungspartner (150b) zum Verbinden zusammengefügt werden und nach dem Verbinden den Legierungsbereich (150) bilden.

9. Herstellungsverfahren nach Anspruch 7 oder 8, wobei der Legierungsbereich (150) eine Au-Si-Legierung aufweist.

10. Herstellungsverfahren nach Anspruch 7 oder 8, wobei der Legierungsbereich (150) eine Ge-Al-Legierung aufweist.

11. Herstellungsverfahren nach einem der Ansprüche 7 bis 10, wobei das mikromechanische Bauelement eine Infrarotsensorvorrichtung ist.
